# EUROPÄISCHE PATENTSCHRIFT

(11) **EP 0 413 938 B1**
(45) Veröffentlichungstag und Bekanntmachung des Hinweises auf die Patenterteilung: **06.12.1995**
(21) Anmeldenummer: 90113042.7
(22) Anmeldetag: 07.07.1990
(51) Int. Cl.: H03K 17/18, H03K 17/06, H03K 17/08, H03K 19/003

(54) **Schaltung zur Überwachung des Schaltstatus eines Leistungstransistors**
Circuit for monitoring the switching state of a power transistor
Circuit pour surveiller l'état de commutation d'un transistor de puissance

(30) Priorität: 22.08.1989 DE 3927647
(43) Veröffentlichungstag der Anmeldung: 27.02.1991
(73) Patentinhaber: WABCO GmbH, 30453 Hannover (DE)
(72) Erfinder: Gröger, Jens, D-3000 Hannover 1 (DE); Hesse, Karl-Heinz, D-3007 Gehrden (DE); Gudat, Wolfgang, D-3016 Seelze 7 (DE); Ruhnau, Gerhard, D-3057 Neustadt (DE)
(74) Vertreter: Schrödter, Manfred, Dipl.-Ing.

(56) Entgegenhaltungen:
- EP-A- 0 082 493
- EP-A- 0 095 579
- EP-A- 0 197 707
- EP-A- 0 245 819
- DE-A- 3 150 703
- DE-A- 3 322 932
- DE-A- 3 621 375
- US-A- 0 255 067
- US-A- 4 363 068
- US-A- 4 441 136
- SIEMENS COMPONENTS, 25. Jahrgang, 1987, Heft 5, SIEMENS AG, Berlin und München;P.BRAUSCHKE - P. SOMMER "Smart sipmos: Leistungshalbleiter mit Intelligenz" Seiten 182-184

## Beschreibung

Die Erfindung bezieht sich auf eine Schaltung zur Überwachung des Schaltstatus eines Leistungstransistors gemäß dem Oberbegriff des Patentanspruchs 1.

In neuerer Zeit sind sogenannte "intelligente" Leistungstransistoren bekannt geworden, die sich selber mittels integrierter Sensoren und integrierter Elektronik gegen Kurzschluß, Überspannung und Übertemperatur schützen können (Zeitschrift Siemens Components 25 (1987) Heft 5).

Diese Transistoren weisen hierzu eine zusätz- lich im Gehäuse integrierte Überwachungseinrichtung auf. welche den Transistor bei Vorliegen unzulässiger Betriebsbedingungen abschaltet. Hierdurch wird der Leistungstransistor vor Zerstörung geschützt.

Über einen sogenannten Status-Ausgang ist es weiter möglich, einem übergeordneten Mikrocomputer zu melden, ob ein Kurzschluß oder ein Leerlauf (Unterbrechung) der Last vorliegt.

Im allgemeinen nicht mit erfaßt wird jedoch ein unvollständiger Kurzschluß bzw. ein sogenannter Nebenschluß, d.h. ein zu kleiner Widerstand der Last. Dieser ergibt sich z.B. dann, wenn eine Last mit echtem Kurzschluß über eine lange Verbindungsleitung angeschlossen ist. Ein solcher Fehler erzeugt einen überhöhten Strom, der nach einiger Zeit zur Überhitzung des Transistors und/oder der Last führt.

Neben der Last kann aber auch der Endtransistor selbst defekt sein. Dies ist der Fall, wenn er im ansteuerungsmäßig gesperrten Zustand trotzdem einen sogenannten Leckstrom durchläßt. Auch dieser Fehler muß unbedingt angezeigt werden, wenn der Leckstrom unzulässig hohe Werte überschreitet, um entsprechende Gegenmaßnahmen treffen zu können.

Schließlich ist aus der US-PS 4,441,136 eine Schaltung zur Erkennung eines Fehlers im einem Schalttransistor oder der geschalteten Last bekannt. Hierbei werden die Spannungen über dem Transistor und der Last abgefühlt. Die Schaltung führt drei Schmelzwertmessungen durch. Sie besitzt einen Logikteil, der die abgefühlten Spannungen mit dem Eingangssignal des Schalttransistors verknüpft. Mit zwei Status-Ausgängen wird angezeigt, ob ein Fehler vorliegt, und ob es sich um einen ernsten Fehler handelt.

Bei der bekannten Schaltung sind die Status-Ausgänge im fehlerfreien Zustand immer Eins, und wechseln nur bei einem Fehler bzw. einer Unregelmäßigkeit auf Null. Dies hat aber den Nachteil, daß z. B. ein eventueller Fehler im letzten ODER-Gatter der Prüfschaltung nicht erkannt wird. Falls der dortige Ausgangstransistor also einen derartigen Fehler hat, daß er nur noch das Signal Eins abgeben kann, können Fehler im Schalttransistor von der bekannten Schaltung nicht mehr erkannt werden.

Der Erfindung liegt die Aufgabe zugrunde, ein Schnelles Verfahren zur Überwachung eines Leistungstransistors und einer von ihm gesteuerten Last mit Hilfe eines Mikroprozessors anzugeben.

Dabei soll insbesondere ein Nebenschluß in der last mit erfaßt sein.

Weiter soll das Verfahren selbst einfach und sicher sein.

Diese Aufgabe wird durch die im Patentanspruch 1 enthaltene Erfindung gelöst. Die Unter-ansprüche enthalten zweckmäßige Weiterbildungen der Erfindung.

Die Erfindung wird im folgenden anhand eines zeichnerisch dargestellten Ausführungsbeispiels näher erläutert. Die Zeichnung zeigt in
**Fig.1** eine Schaltung zur Statuserkennung gemäß dem Stand der Technik, und in
**Fig.2** eine Schaltung zur Statuserkennung gemäß der Erfindung.

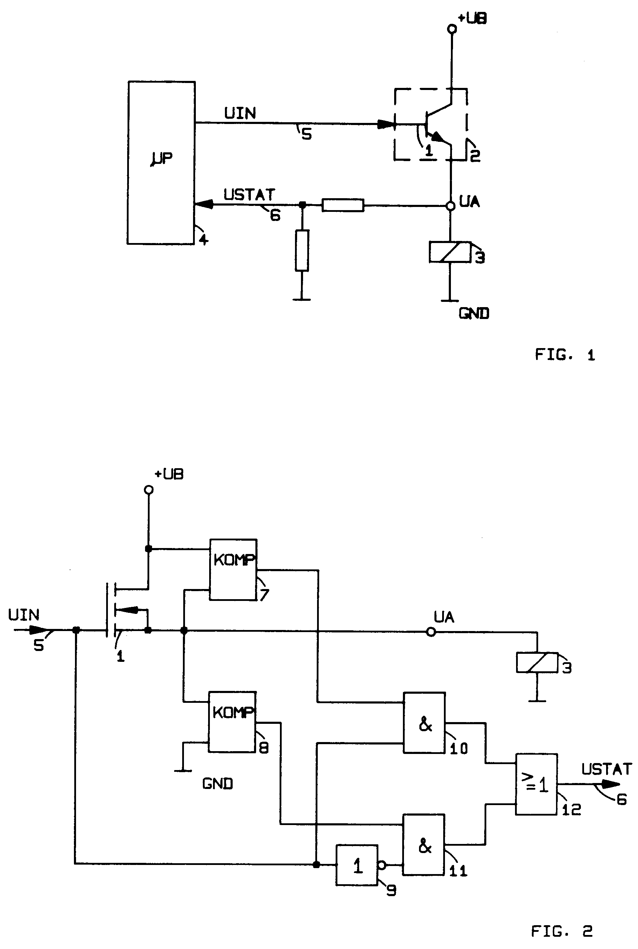

In der Fig.1 ist schematisch eine gebräuchliche Schaltung zur Statuserkennung eines Endtransistors (1) sowie einer Last (3) dargestellt. Die Last (3), hier eine Spule eines Magnetventils, wird von einer Batteriespannung (+ U_{B}) über den Endtransistor (1) versorgt. Der Endtransistor (1) ist Teil einer Verstärkerschaltung (2), die noch weitere elektronische Elemente enthält (nicht dargestellt). Die Verstärkerschaltung (2) wird von einem Mikroprozessor (4) über eine Leitung (5) mit einem Eingangssignal (U_{IN}) angesteuert. Der Zustand des Transistors (1) sowie der Last (3) wird am Verbindungspunkt (U_{A}) abgetastet und über eine Leitung (6) als Statussignal (U_{Stat}) dem Mikroprozessor (4) zugeleitet.

Der Mikroprozessor (4) verknüpft das Ansteuersignal (U_{IN}) mit dem Statussignal (U_{Stat}) und erkennt daraus den Zustand von Endtransistor (1) und Last (3). Der Statuseingang des Mikroprozessors kann High- oder Low-Signale auswerten, wobei ein Low-Signal z.B. kleiner als 2 V, und ein High-Signal z.B. größer als 4 V sein muß.

Die Batteriespannung (+ U_{B}) beträgt beispielsweise 12 V. Der Widerstand des Endtransistors (1) im leitenden Zustand beträgt beispielsweise 0,25 Ω. Der Widerstand der Last (3) beträgt beispielsweise 15 Ω.

Falls im leitenden Zustand des Transistors (1) die Spannung (U_{A}) eine Statusspannung (U_{Stat}) von > 4 V erzeugt, erkennt der Mikroprozessor, daß die Last (3) in Ordnung sein muß. Falls jedoch ein (U_{Stat}) von < 2 V erzeugt wird, erkennt der Mikroprozessor, daß ein Kurzschluß der Last vorliegen muß.

Falls im abgeschalteten Zustand des Transistors (1) das Statussignal (U_{Stat}) einen High-Wert hat, erkennt der Mikroprozessor eine Unterbrechung der Last (3) (open load), oder einem Leckstrom des Transistors, falls dieser eine bestimmte Größe übersteigt.

Der Nachteil bzw. Mangel der bekannten Schaltung nach der Fig.1 liegt nun darin, daß ein sogenannter Nebenschluß der Last (3) im Wert von beispielsweise 0,6 Ω durch die Schaltung nicht erfaßt wird, da infolge des hohen dann von der Batterie gelieferten Stromes die Statusspannung (U_{Stat}) auf dem High-Level bleibt. Dem Mikroprozessor (4) wird damit eine intakte Last (3) angezeigt, obwohl diese einen zu hohen Strom zieht.

Diese Nachteile werden durch die erfindungsgemäße Schaltung nach der Fig.2 beseitigt. Diese besteht wiederum aus einem Leistungstransistor (1), der von einer Batteriespannug (+ U_{B}) versorgt wird, und eine Last (3) ansteuert. Das Eingangssignal (U_{IN}) wird auf der Leitung (5) zur Basis des Transistors (1) geleitet. Das Statussignal (U_{Stat}) wird auf der Leitung (6) ausgekoppelt. Wie in Fig.1 dargestellt, sind die Leitungen (5) und (6) mit einem (nicht gezeigten) Mikroprozessor verbunden.

Ähnlich wie in der Fig.1 wird die Spannung (U_{A}) über der Last (3) ausgewertet. Hierzu wird ein Komparator (8) verwendet, welcher bei einer Eingangsspannung von kleiner als beispielsweise 2 V ein Low-Signal und bei einer Eingangsspannung von größer als beispielsweise 4 V ein High-Signal abgibt.

Zusätzlich zur in der Fig.1 dargestellten Anordnung wird ebenfalls die Spannung über dem Leistungstransistor (1) mittels eines weiteren Komparators (7) abgetastet. Falls diese im leitenden Zustand des Transistors (1) kleiner ist als beispielsweise 2 V gibt der Komparator (7) ein High-Signal ab. Bei einem größeren Spannungsabfall über dem Transistor (1) als 2 V gibt er ein Low-Signal ab.

Die Ausgänge der beiden Komparatoren (7) und (8) sind zwei UND-Gliedern (10) und (11) zugeführt. Der zweite Anschluß des UND-Glieds (10) ist mit der Leitung (5), also dem Ansteuersignal (U_{IN}) des Transistors (1) verbunden.Der zweite Anschluß des UND-Glieds (11) ist über einen Inverter (9) ebenfalls mit der Leitung (5) verbunden.

Die Ausgänge der UND-Glieder (10) und (11) sind über ein ODER-Glied (12) zusammengefaßt, dessen Ausgangsleitung (6) das Statussignal (U_{Stat}) führt.

Die erfindungsgemäße Schaltung nach Fig.2 funktioniert wie folgt.

Mit dem Komparator (7) über dem Leistungstransistor (1) wird der Zustand des eingeschalteten Leistungstransistors (U_{IN} = High) untersucht. Falls die am Transistor abfallende Spannung (U_{B} - U_{A}) < 2 V ist, gibt der Komparator (7) ein High-Signal ab. Dieses wird über das nun angesteuerte UND-Glied (10) sowie das ODER-Glied (12) auf die Statusleitung (6) weitergegeben.

Der Mikroprozessor erkennt damit, daß die Last (3) in Ordnung ist und der Transistor (1) leitet.

Falls jedoch das Ausgangssignal des Komparators (7) Low ist, d.h. ein zu hoher Spannungsabfall am Transistor (1) auftritt, erkennt der übergeordnete Mikroprozessor, daß ein Überlastzustand oder ein Kurzschluß der Last (3) vorliegen muß, oder daß der Transistor (1) nicht vollständig leitet.

Zur Unterscheidung dient der weitere Komparator (8). Mit diesem wird die Spannung über der Last (3) dann geprüft, wenn das Eingangssignal (U_{IN}) des Transistors (1) einen Low-Pegel aufweist, d.h. der Transistor (1) gesperrt ist. Falls in diesem Zustand die Spannung (U_{A}) einen Wert von kleiner oder gleich 2 V hat, erkennt der übergeordnete Mikroprozessor, daß die Last (3) in Ordnung und der Transistor (1) gesperrt ist. In diesem Fall gibt der Komparator (8) ein Low-Signal ab, welches über das jetzt eingeschaltete UND-Glied (11) sowie das ODER-Glied (12) als Statussignal (U_{Stat}) ausgegeben wird.

Falls die Spannung (U_{A}) größer oder gleich 4 V ist, gibt der Komparator (8) ein High-Signal ab, das wieder als (U_{Stat}) auf der Leitung (6) ausgegeben wird. In diesem Fall schließt der Mikroprozessor (4) auf einen Kurzschluß des Transistors (1) oder einen zu großen Leckstrom des Transistors (1), oder auf eine Unterbrechung (open load) der Last (3).

Der wesentliche Vorteil der Schaltung nach der Fig.2 besteht darin, daß man mit ihr im eingeschalteten Zustand des Transistors (1) den sonst nicht leicht nachzuweisenden Fehler des sogenannten Nebenschlusses der Last und im ausgeschalteten Zustand Leckströme des Transistors (1) erfassen kann.

Somit kann erkannt werden, ob die Last entsprechend der Ansteuerung wirklich ein- bzw. ausgeschaltet ist.

Die gesamte Schaltung nach der Fig.2 ist vorteilhatt im Gehäuse des Leistungstransistors (1) mit integriert.

Die Schaltung gemäß der Erfindung kann natürlich auch anders ausgebildet sein als in der Fig.2 beispielhaft dargestellt, ohne den Rahmen des Erfindungsgedankens zu verlassen.

So kann beispielsweise anstelle der UND-Glieder (10, 11) ein besonderer Eingang der Komparatoren (7, 8) vorgesehen sein, durch welchen diese vom Eingangssignal (U_{IN}) aktivierbar sind.

Weiter können auch die Ausgänge der Komparatoren (7, 8) direkt an den Mikroprozessor (4) angeschaltet sein und von diesem entsprechend ausgewertet werden.

## Patentansprüche

1. Verfahren zur Überwachung eines Leistungstransistors (1) und einer von diesem gesteuerten Last (3), wobei die Spannung über der Last (3) überwacht und ein Statussignal (U_{Stat}) erzeugt wird und aus entsprechend der Transistor-Ansteuerung (U_{IN}) sich ergebenden Statussignalwerten und zugehörigen Ansteuersignalen (U_{IN}) des Leistungstransistors (1) mittels eines Mikroprozessors (4) auf einen Fehler im Leistungstransistor (1) oder in der Last (3) geschlossen wird, gekennzeichnet durch folgende Schritte:
a) der Leistungstransistor (1) wird mittels des Mikroprozessors (4) zum Einschalten angesteuert (U_{IN} = High),
b) mittels eines ersten Komparators (7) wird gemessen, ob die Spannung über dem Leistungstransistor (1) kleiner als eine erste Schwelle ist, also die Last (3) in Ordnung ist und der Leistungstransistor (1) leitet,
c) zur Unterscheidung, ob andernfalls ein Überlastzustand oder ein Kurzschluß der Last (3) vorliegt oder der Leistungstransistor (1) nicht vollständig leitet, wird der Leistungstransistor (1) mittels des Mikroprozessors (4) für eine Sperrung angesteuert (U_{IN} = Low) und
d) mittels eines zweiten Komparators (8) gemessen, ob die Spannung über der Last (3) kleiner oder gleich einer zweiten Schwelle ist, also die Last (3) in Ordnung, und der Leistungstransistor (1) gesperrt ist oder die Spannung über der Last (3) größer oder gleich einer dritten Schwelle ist, also der Leistungstransistor (1) einen Kurzschluß oder zu großen Leckstrom aufweist oder die Last unterbrochen ist,
e) das Statussignal (U_{Stat}) wird aus den Ausgangssignalen der beiden Komparatoren (7, 8) gebildet und ist im Mikroprozessor (4) in Verbindung mit dem Ansteuersignal dahingehend auswertbar, daß bei deren logischer Übereinstimmung in den Schritten a), b) und c), d) auf Fehlerfreiheit des überwachten Leistungtransistors und der gesteuerten Last geschlossen wird.

2. Verfahren nach Anspruch 1, dadurch gekennzeichnet, daß die erste Schwelle und die zweite Schwelle etwa 2 V und die dritte Schwelle etwa 4V betragen.

3. Verfahren nach Anspruch 1 bis 2, dadurch gekennzeichnet, daß im eingeschalteten Zustand des Leistungstransistors (1) durch sein Ansteuersignal (U_{IN} = High) der Komparator (7) über dem Leistungstransistor (1) und im ausgeschalteten Zustand des Leistungstransistors (1) durch das Ansteuersignal (U_{IN} = Low) des Leistungstransistors (1) der Komparator (8) über der Last (3) aktivierbar sind.

4. Verfahren nach Anspruch 3, dadurch gekennzeichnet, daß den beiden Komparatoren (7,8) jeweils ein UND-Glied (10, 11) nachgeschaltet ist, wobei das erste UND-Glied (10) von dem Ansteuersignal (U_{IN}) direkt, und das zweite UND-Glied (11) über einen Inverter (9) einschaltbar ist.

5. Verfahren nach Anspruch 4, dadurch gekennzeichnet, daß die Ausgangssignale der UND-Glieder (10, 11) über ein ODER-Glied (12) zu dem Statussignal (U_{Stat}) zusammengefaßt werden.

## Claims

1. Method for monitoring a power transistor (1) and a load (3) controlled by it, in which the voltage across the load (3) is monitored, a status signal (U_{Stat}) is produced and an error in the power transistor (1) or in the load (3) is deduced by means of a microprocessor (4) from status signal values occurring in accordance with the transistor activation (U_{IN}) and from associated activation signals (U_{IN}) of the power transistor (1), which method is characterised by the following steps:
a) the power transistor (1) is activated by the microprocessor (4) to switch on (U_{IN} = High),
b) a first comparator (7) measures whether the voltage across the power transistor (1) is lower than a first threshold, that is to say, the load (3) is in order and the power transistor (1) is conducting,
c) in order to distinguish, when that is not the case, whether there is overloading or a short circuit in the load (3) or whether the power transistor (1) is not conducting fully, the power transistor (1) is activated by the microprocessor (4) not to conduct (U_{IN} = Low), and
d) a second comparator (8) measures whether the voltage across the load (3) is less than or equal to a second threshold, that is to say, the load (3) is in order and the power transistor (1) is not conducting, or whether the voltage across the load (3) is greater than or equal to a third threshold, that is to say, the power transistor (1) has a short circuit or too large a leakage current or the load is interrupted,
e) the status signal (U_{Stat}) is formed from the output signals of the two comparators (7, 8) and can be evaluated, together with the activation signal, in the microprocessor (4) to the effect that when those signals are in logical agreement in steps a), b) and c), d) the monitored power transistor and the controlled load are held to be error-free.

2. Method according to claim 1, characterised in that the first threshold and the second threshold are approximately 2 V and the third threshold is approximately 4 V.

3. Method according to claims 1 and 2, characterised in that when the power transistor (1) is switched on the comparator (7) across the power transistor (1) is arranged to be activated by the latter's activation signal (U_{IN} = High) and when the power transistor (1) is switched off the comparator (8) across the load (3) is arranged to be activated by the activation signal (U_{IN} = Low) of the power transistor (1).

4. Method according to claim 3, characterised in that an AND element (10, 11) is connected downstream of each of the two comparators (7, 8), the first AND element (10) being arranged to be switched on directly by the activation signal (U_{IN}) and the second AND element (11) being arranged to be switched on by way of an inverter (9).

5. Method according to claim 4, characterised in that the output signals of the AND elements (10, 11) are combined via an OR element (12) to form the status signal (U_{Stat}).

## Revendications

1. Procédé pour la surveillance d'un transistor de puissance (1) et d'une charge (3) commandée par celui-ci, la tension étant surveillée par l'intermédiaire de la charge (3) et un signal d'état (U_{Stat}) étant engendré, et des valeurs de signal d'état résultant de la commande de transistor (U_{IN}) de façon correspondante et des signaux de commande (U_{IN}) associés du transistor de puissance (1), au moyen d'un microprocesseur (4), servant à la conclusion d'un défaut dans le transistor de puissance (1) ou dans la charge (3), caractérisé par les étapes suivantes :
a) le transistor de puissance (1) est commandé pour mise en service au moyen du microprocesseur (4) (U_{IN} = élevé),
b) au moyen d'un premier comparateur (7), est mesuré si la tension, par l'intermédiaire du transistor de puissance (1), est plus petite qu'un premier seuil, alors, la charge (3) est en ordre et le transistor de puissance (1) conduit,
c) pour la discrimination, si, dans un autre cas, un état de surcharge ou un court-circuit de la charge (3) sont présents, ou le transistor de puissance (1) ne conduit pas complètement, le transistor de puissance (1), au moyen du microprocesseur (4), est commandé pour un blocage (U_{IN} = bas), et
d) au moyen d'un deuxième comparateur (8), est mesuré si la tension, par l'intermédiaire de la charge (3), est plus petite ou égale à un deuxième seuil, alors, la charge (3) est en ordre et le transistor de puissance (1) est bloqué, ou si la tension, par l'intermédiaire de la charge (3), est plus grande ou égale à un troisième seuil, alors, le transistor de puissance (1) présente un court-circuit ou un trop grand courant de fuite, ou la charge est interrompue,
e) le signal d'état (U_{Stat}) est formé à partir des signaux de sortie des deux comparateurs (7, 8) et est, en liaison avec le signal de commande, susceptible d'être évalué dans le microprocesseur (4) de façon telle, que, lors de leur coïncidence logique dans les étapes a), b) et c), d), il est décidé sur l'absence de défaut du transistor de puissance à surveiller et de la charge commandée.

2. Procédé selon la revendication 1, caractérisé en ce que le premier seuil et le deuxième seuil atteignent à peu près 2 V et le troisième seuil atteint à peu près 4 V.

3. Procédé selon la revendication 1, et la revendication 2, caractérisé en ce que, dans l'état en service du transistor de puissance (1), grâce à son signal de commande (U_{IN} = élevé), le comparateur (7), par l'intermédiaire du transistor de puissance (1), et, dans l'état hors service du transistor de puissance (1), grâce au signal de commande (U_{IN} = bas) du transistor de puissance (1), le comparateur (8), sont susceptibles d'être activés par l'intermédiaire de la charge (3).

4. Procédé selon la revendication 3, caractérisé en ce qu'aux deux comparateurs (7, 8), chaque fois, un élément de circuit ET (10, 11) est mis en circuit en aval, le premier élément de circuit ET (10) étant susceptible d'être mis en service directement par le signal de commande (U_{IN}) et le deuxième élément de circuit ET (11) étant susceptible d'être mis en service par l'intermédiaire d'un inverseur (9).

5. Procédé selon la revendication 4, caractérisé en ce que les signaux de sortie des éléments de circuit ET (10, 11), sont rassemblés, par l'intermédiaire d'un élément de circuit OU (12), en le signal d'état (U_{Stat}).
